# EUROPÄISCHE PATENTANMELDUNG

(11) **EP 2 461 428 A1**
(43) Veröffentlichungstag der Anmeldung: **06.06.2012**
(21) Anmeldenummer: 11008497.7
(22) Anmeldetag: 22.10.2011
(51) Int. Cl.: H01R 13/10, G01R 11/04

(54) **Zähltraggehäuse für einen Zählerschrank**

(30) Priorität: 01.12.2010 DE 102010053136
(71) Anmelder: ABB AG, 68309 Mannheim (DE)
(72) Erfinder: Wieland, Ralf, 69429 Waldbrunn (DE); Eppe, Klaus- Peter, 69429 Waldbrunn (DE); Siedelhofer, Bernd, 69121 Heidelberg (DE)

(57) **Zusammenfassung**

Die Erfindung betrifft ein Zählertraggehäuse (10) für einen Zählerschrank zur Montage eines Zählers,mit wenigstens einer ersten zugangsseitigen Einführöffnung (16) für die Aufnahme wenigstens eines zugangsseitigen Phasenleiters (17a, 17b, 17c), mit einer zweiten zugangsseitigen Einführöffnung für die Aufnahme eines zugangsseitigen Neutralleiters (17d), und mit wenigstens einer ersten ausgangsseitigen Abgangsöffnung für die Aufnahme wenigstens eines abgangsseitigen Phasenleiters (19a, 19b, 19c), wobei der zugangsseitig eingeführte Neutralleiter (17d) im Inneren des Zählertraggehäuses (10) von der ersten zugangsseitigen Einführöffnung aus elektrisch zu einer zweiten ausgangsseitigen Abgangsöffnung durchschleifbar ist, mit wenigstens einem U-förmigen Kontaktstück (23), mit dem eine am Stromzähler befindliche Kontaktfahne bei der Montage des Stromzählers in Eingriff bringbar ist, wobei die Kontaktfahne durch einen Schlitz (29, 30) hindurch ins Innere des Zählertraggehäuses (10) einführbar ist. An dem U-förmigen Kontaktstück (23) ist eine zugangsseitige Anschlussfahne (35) und eine abgangsseitige Anschlussfahne (39) angeformt, und an der zugangsseitigen Anschlussfahne (38) ist ein zugangsseitig eingeführtes Neutralleiter-Teilstück (17d) und an der abgangsseitigen Anschlussfahne (39) ein in der zweiten ausgangsseitigen Abgangsöffnung eingeführtes abgangsseitiges Neutralleiter-Teilstück (19d) anschließbar.

## Beschreibung

Die Erfindung betrifft ein Zählertraggehäuse für einen Zählerschrank zur Montage eines Zählers, mit wenigstens einer ersten zugangsseitigen Einführöffnung für die Aufnahme wenigstens eines zugangsseitigen Phasenleiters, mit einer zweiten zugangsseitigen Einführöffnung für die Aufnahme eines zugangsseitigen Neutralleiters, und mit wenigstens einer ersten ausgangsseitigen Abgangsöffnung für die Aufnahme wenigstens eines abgangsseitigen Phasenleiters, wobei der zugangsseitig eingeführte Neutralleiter im Inneren des Zählertraggehäuses von der ersten zugangsseitigen Einführöffnung aus elektrisch zu einer zweiten ausgangsseitigen Abgangsöffnung durchschleifbar ist, mit wenigstens einem U-förmigen Kontaktstück, mit dem eine am Stromzähler befindliche Kontaktfahne bei der Montage des Stromzählers in Eingriff bringbar ist, wobei die Kontaktfahne durch einen Schlitz hindurch ins Innere des Zählertraggehäuses einführbar ist, gemäß dem Oberbegriff des Anspruchs 1.

Aus der DE 10 2004 022 783 B4 oder aus der DE 10 2004 022 785 A1 sind Zählertraggehäuse bekannt mit wenigstens einer ersten zugangsseitigen Einführöffnung für die Aufnahme wenigstens eines zugangsseitigen Phasenleiters, mit einer zweiten zugangsseitigen Einführöffnung für die Aufnahme eines zugangsseitigen Neutralleiters, und mit wenigstens einer ersten ausgangsseitigen Abgangsöffnung für die Aufnahme wenigstens eines abgangsseitigen Phasenleiters, und mit wenigstens einem U-förmigen Kontaktstück, mit dem eine am Stromzähler befindliche Kontaktfahne bei der Montage des Stromzählers in Eingriff bringbar ist, wobei die Kontaktfahne durch einen Schlitz hindurch ins Innere des Zählertraggehäuses einführbar ist.

Ein Stromzähler, beispielsweise ein elektronischer Haushaltszähler, der mit Kontaktfahnen an seiner Unterseite versehen ist, kann zur Montage auf das Zählertraggehäuse aufgesetzt werden, wobei innerhalb des Zählertraggehäuses Kontaktstücke vorgesehen sind, mit denen die Kontaktfahnen in elektrisch leitende Verbindung bringbar sind. Die Kontaktstücke sind dabei üblicherweise U-förmig ausgebildet und über an einem der Schenkel der U-Form angeschlossene Anschlussfahnen mit den Zu- bzw. Abgangsleitern verbunden.

Das Zählertraggehäuse hat eine im wesentlichen quaderförmige Gestalt. In seiner oberen Breitseite sind Schlitze zur Aufnahme der Kontaktfahnen des Stromzählers vorhanden.

Ein solches Zählertraggehäuse wird auch als Befestigungs- und Kontaktiereinrichtung, abgekürzt BKE, für einen Stromzähler bezeichnet. Wenn der BKE in dem Zählerschrank der Installationsanlage fest eingebaut ist, bildet der BKE einen Teil des Zählerplatzes, er ist gewissermaßen in den Zählerplatz integriert und wird dann auch kurz als BKE-I bezeichnet. Ein BKE-I hat an einer ersten Schmalseite des Gehäuses, die hier daher auch als Einführ-Schmalseite oder auch Zugangsseite bezeichnet wird, Einführöffnungen für die Aufnahme von Zugangsleitern bei der Installation in dem Zählerschrank, auch als Anschlussleiter bezeichnet. Anschlussleiter können Phasenleiter oder ein Neutralleiter sein. Phasenleiter und Neutralleiter, die an der Zugangsseite eingeführt werden, sind dann zugangsseitige Phasenleiter und zugangsseitige Neutralleiter.

An einer zweiten Schmalseite, die hier daher auch als Abgangs-Schmalseite bezeichnet wird, und die der Einführ-Schmalseite üblicherweise gegenüberliegt, hat ein BKE-I Ausgangsöffnungen für die Aufnahme von Abgangsleitern bei der Installation in dem Zählerschrank. Abgangssleiter können Phasen leiter oder ein Neutralleiter sein. Phasenleiter und Neutralleiter, die an der Abgangsseite eingeführt werden, sind dann abgangsseitige Phasenleiter und abgangsseitige Neutralleiter.

Der Stromzähler ist also mittels eines BKE-I im Zählerschrank elektrisch zwischen den Zugangs- und den Abgangsleitern geschaltet.

Bekannt sind BKE-I Zählertraggehäuse für dreiphasige Anwendungen. Sie haben mindestens drei Einführöffnungen für die Aufnahme der drei zugangsseitigen Phasenleiter L1, L2, L3, und oft noch eine weitere Einführöffnung für die Aufnahme eines zugangsseitigen Neutralleiters N. Der Neutralleiter N dient zur Versorgung des elektronischen Stromzählers. Weiter haben bekannte BKE-I Zählertraggehäuse drei Ausgangsöffnungen für die Aufnahme der drei abgehenden Phasenleiter L1, L2, L3.

Es sind auch BKE-I Zählertraggehäuse für einphasige Anwendungen bekannt. Diese haben eine Einführöffnung für die Aufnahme eines Phasenleiters, beispielsweise des Phasenleiters L2, eine weitere Einführöffnung für die Aufnahme eines zugangsseitigen Neutralleiters N, sowie eine Ausgangsöffnung zur Aufnahme eines abgehenden Phasenleiters, beispielsweise wieder L2.

Bei der Montage in dem Zählerschrank befinden sich die Zugangsleiter im unteren Anschlussraum, und die Abgangsleiter befinden sich im oberen Anschlussraum. Zwischen dem unteren und dem oberen Anschlussraum befindet sich der BKE mit dem Zähler.

In einem solchen Stromzählersystem ist es erforderlich, dass der N-Leiter vom unteren in den oberen Anschlussraum geführt wird. Heute wird das so gemacht, dass ein separates N-Leiterkabel in den oberen Anschlussraum geführt wird. Dadurch entstehen höhere Kosten, da eine zusätzliche Leitung verlegt werden muss. Weiter gestaltet sich die Verlegung des zusätzlichen N-Leiter-Kabels aus Platzgründen in dem Zählerschrank oft schwierig.

Aus der EP 1 901 078 A2 ist ein BKE-I Zählertraggehäuse bekannt, bei dem ein Neutralleiterkabel vom unteren Anschlussraum in den oberen Anschlussraum durchgehend innerhalb des Zählertraggehäuses verlegt ist. Die Verbindung zwischen dem Neutralleiterkabel und dem U-förmigen Kontaktstück ist durch eine Lasche hergestellt, welche durch die Litzen des Neutralleiterkabels hindurchgesteckt und am Ende abgebogen ist. Bei einem solchen Zählertraggehäuse kann entweder ein vom unteren Anschlussraum in den oberen Anschlussraum führendes Neutralleiterkabel vorhanden sein, oder gar kein Neutralleiterkabel. Ein Lösung mit einem nur im unteren Anschlussraum vorgesehenen Neutralleiterkabel ist damit nicht realisierbar.

Es ist daher die Aufgabe der vorliegenden Erfindung, ein Zählertraggehäuse zu schaffen, bei dem auf einfache Weise sowohl ein Neutralleiter von dem unteren in den oberen Anschlussraum eines Stromzählersystems durchgeschleift werden kann, als auch ein Neutralleiter nur im unteren Anschlussraum angeschlossen werden kann.

Es ist eine weitere Aufgabe der vorliegenden Erfindung, einen Zählerschrank zu schaffen, der hinsichtlich der Durchschleifung des Neutralleiters von dem unteren in den oberen Anschlussraum und hinsichtlich des Anschlusses eines Neutralleiters nur im unteren Anschlussraum vereinfacht ist.

Die Aufgabe wird gelöst durch ein Zählertraggehäuse mit den kennzeichnenden Merkmalen des Anspruchs 1.

Die Aufgabe wird hinsichtlich des Zählerschranks gelöst durch Anspruch 8.

Erfindungsgemäß also ist an dem U-förmigen Kontaktstück eine zugangsseitige Anschlussfahne und eine abgangsseitige Anschlussfahne angeformt, und an der zugangsseitigen Anschlussfahne ist ein zugangsseitig eingeführtes Neutralleiter-Teilstück und an der abgangsseitigen Anschlussfahne ist ein in der zweiten ausgangsseitigen Abgangsöffnung eingeführtes abgangsseitiges Neutralleiter-Teilstück anschließbar.

Die zugangsseitige Anschlussfahne ist dabei eine Anschlussfahne, die in Richtung auf die Zugangsseite des Zählertraggehäuses hin weist, wenn das Kontaktstück in dem Zählertraggehäuse eingebaut ist. Die abgangsseitige Anschlussfahne ist dabei eine Anschlussfahne, die in Richtung auf die Abgangsseite des Zählertraggehäuses hin weist, wenn das Kontaktstück in dem Zählertraggehäuse eingebaut ist.

Das erfindungsgemäße Zählertraggehäuse kann dabei, ohne Änderungen vornehmen zu müssen, sowohl bei Anwendungen mit zwischen dem unteren und dem oberen Anschlussraum durchgeschleiften Neutrallleiter als auch bei Anwendungen ohne durchgeschleiften Neutralleiter, also wenn nur im unteren Anschlussraum ein Neutralleiter angeschlossen ist, verwendet werden. Bei letzterer Anwendung bleibt die abgangsseitige Anschlussfahne unbelegt, nur an der zugangsseitigen Anschlussfahne wird das zugangsseitig eingeführte Neutralleiter-Teilstück angeschlossen. Der Vorteil liegt dabei darin, dass über das U-förmige Kontaktstück sowohl das elektrische Durchschleifen des Neutralleiters durch das Zählertraggehäuse hindurch von der Einführöffnung zu der Abgangsöffnung hin bewirkt wird, und gleichzeitig die elektrische Verbindung des auf das Zählertraggehäuse aufgesetzten Zählers mit dem an die zugangsseitige Anschlussfahne angeschlossenen Neutralleiter-Teilstücks erfolgt.

Bei der erfindungsgemäßen Ausführungsform sieht es bei zu- und abgangsseitig angeschlossenem Neutralleiter von außen bei geschlossenem Zählertraggehäuse so aus, als ob der Neutralleiter von der zugangsseitigen Einführöffnung durch das Zählertraggehäuse hindurch geführt und an der abgangsseitigen Abgangsöffnung wieder herauskommt. Er besteht dabei aus zwei Teilstücken, einem zugangsseitg eingeführten und einem abgangsseitig eingeführten Neutralleiter-Teilstück, die beide durch Verbinden mit Anschlussfahnen des auch zur Kontaktierung des Zählers dienenden U-förmigen Kontaktstücks elektrisch miteinander verbunden sind, was auch als Durchschleifen bezeichnet werden kann.

Gemäß einer vorteilhaften Ausführungsform der Erfindung sind das zugangsseitige und das abgangsseitige Neutralleiter-Teilstück an der zugangsseitigen bzw. der abgangsseitigen Anschlussfahne schraubenlos angeformt. Dadurch ist der Vorteil bewirkt, dass die Montage des Zählertraggehäuses in dem Zählerplatz beziehungsweise in dem Zählerschrank vereinfacht ist. Denn die die Montage durchführende Person braucht den Neutralleiter nicht mehr an einer Schraubklemme anzuschrauben.

Gemäß einer vorteilhaften Ausführungsform der Erfindung sind das zugangsseitige und das abgangsseitige Neutralleiter-Teilstück an der zugangsseitigen bzw. der abgangsseitigen Anschlussfahne angeschweißt. In einer besonders einfachen Ausführungsform können dabei die freien Enden des zugangsseitigen und des abgangsseitigen Neutralleiter-Teilstücks direkt auf die Anschlussfahnen angeschweißt sein. Damit ist ein Minimum an Aufwand erforderlich, um eine schraubenlose Verbindung zwischen den freien Enden des zugangsseitigen und des abgangsseitigen Neutralleiters und den Anschlussfahnen zu bewirken.

Gemäß einer vorteilhaften Ausführungsform der Erfindung ist an dem in das Zählertraggehäuse einführbaren Ende des zugangsseitigen und des abgangsseitigen Neutralleiter-Teilstücks jeweils ein Kabelschuh mit einer Anschlusslasche, welche auch als zylindrische Aufnahme für die Kabelenden bezeichnet wird, befestigt, wobei die Anschlusslaschen bzw. zylindrischen Aufnahmen mit der zugangsseitigen bzw. der abgangsseitigen Anschlussfahne schraubenlos verbunden sind. Die Anschlusslaschen bzw. zylindrischen Aufnahmen stabilisieren die mechanische und elektrische Verbindung der Anschlussenden der Teilstücke des Neutralleiters mit den jeweiligen Anschlussfahnen, insbesondere beispielsweise, wenn der Neutralleiter als ein Litzenleiter ausgeführt ist.

Gemäß einer vorteilhaften Ausführungsform der Erfindung sind die Anschlusslaschen bzw. zylindrischen Aufnahmen an der zugangsseitigen bzw. der abgangsseitigen Anschlussfahne angeschweißt. Dadurch ist eine mechanisch sehr feste Verbindung mit einem geringen Übergangswiderstand erreicht.

Gemäß einer vorteilhaften Ausführungsform der Erfindung sind die Anschlusslaschen bzw. zylindrischen Aufnahmen mit der zugangsseitigen bzw. der abgangsseitigen Anschlussfahne verlötet. Dadurch wird ebenfalls eine mechanisch sehr feste Verbindung mit einem geringen Übergangswiderstand erreicht, wobei ein geringerer Wärmeeintrag während der Herstellung der Verbindung bewirkt wird.

Gemäß einer vorteilhaften Ausführungsform der Erfindung ist an der zugangsseitigen bzw. der abgangsseitigen Anschlussfahne ein Crimpelement angeformt, mit dem der zugangsseitige und der abgangsseitige Neutralleiter mit der zugangsseitigen bzw. der abgangsseitigen Anschlussfahne vercrimpt ist. Das vercrimpen ist eine einfache und dennoch zuverlässige mechanische Verbindungstechnik, die ohne Wärmeeintrag zu einer mechanisch festen Verbindung mit einem geringen Übergangswiderstand führt.

Gemäß einer vorteilhaften Ausführungsform der Erfindung sind die zugangsseitige und die abgangsseitige Anschlussfahne an demselben Schenkel des U-förmigen Kontaktstücks angeformt. Damit vereinfacht sich der Aufbau des Kontaktstücks. Das Kontaktstück kann unverändert für Ausführungen mit durchgeschleiftem Neutralleiter und ohne durchgeschleiften Neutralleiter verwendet werden.

Ein erfindungsgemäßer Zählerschrank umfasst ein erfindungsgemäßes Zählertraggehäuse, so dass darin der Neutralleiter zwischen dem unteren und dem oberen Anschlussraum durchgeschleift ist und nicht an anderer Stelle innerhalb des Zählerschrankes als zusätzliche Leitung geführt werden muss.

Weitere vorteilhafte Ausgestaltungen und Verbesserungen der Erfindung und weitere Vorteile sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:
- Figur 1: ein erfindungsgemäßes Zählertraggehäuse mit durchgeschleiftem Neutralleiter,
- Figur 2: ein U-förmiges Kontaktstück zur Verwendung in einem erfindungsgemäβen Zählertraggehäuse mit beidseitig schraubenlos angebrachten Neutralleiterstücken, sowie
- Figur 3: ein U-förmiges Kontaktstück zur Verwendung in einem erfindungsgemäβen Zählertraggehäuse mit beidseitig direkt angeschweißten Neutralleiterstücken.

In den Figuren sind gleiche oder gleichwirkende Bauelemente oder Baugruppen mit denselben Bezugsziffern bezeichnet.

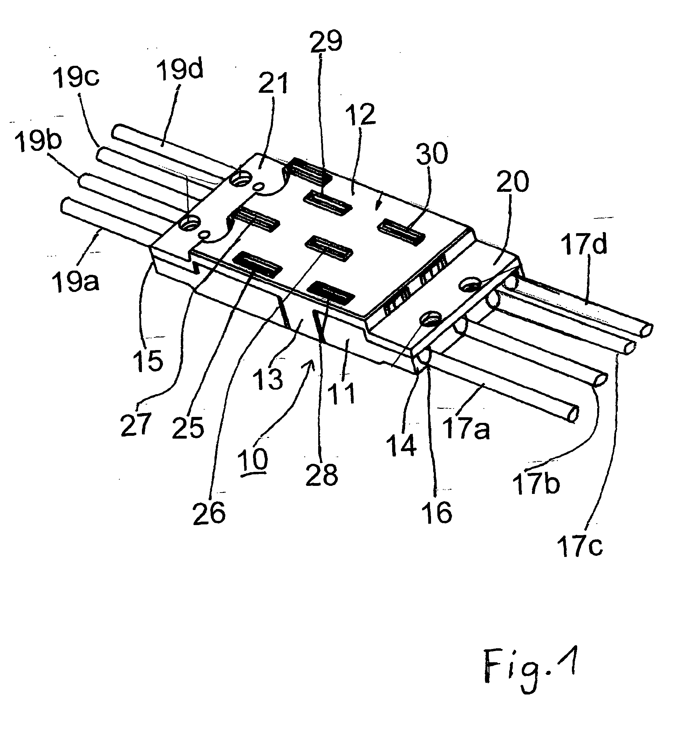

Die Fig. 1 zeigt ein Zählertraggehäuse 10, das in einen Schaltschrank eingebaut werden kann, wie es z. B. in der DE 10 2004 022 785 beschrieben ist. Das Zählertraggehäuse 10 besitzt ein Gehäuseunterteil 11 und ein Gehäuseoberteil 12, an dem Rastarme 13 angeformt sind, mit denen das Gehäuseoberteil 12 am Gehäuseunterteil 11 festgerastet werden kann. Das Zählertraggehäuse 10 ist rechteckig ausgebildet und besitzt auf seinen beiden Schmalseitenwänden 14 und 15, von denen die Schmalseitenwand 15 nicht sichtbar ist, Zugangsöffnungen 16 für zugangsseitige Phasenleiter 17a, 17b, 17c und einen zugangsseitigen Neutralleiter 17d und Abgangsöffnungen (nicht sichtbar da verdeckt) für abgangsseitige Phasenleiter 19a, 19b, 19c und einen abgangsseitigen Neutralleiter 19d.

Die Zugangsöffnungen 16 und Abgangsöffnungen sind durch U-förmige Aussparungen an den Schmalseitenwänden 14 bzw. 15 gebildet, die durch das Gehäuseoberteil mit dessen Abschnitten 20 und 21 abgedeckt sind.

Die zugangsseitige Phasenleiter 17a, 17b, 17c und die abgangsseitige Phasenleiter 19a, 19b, 19c sind mit Kontaktstücken im Inneren des Zählertraggehäuses 10 verbunden. Den Kontaktstücken sind im Gehäuseoberteil 12 Schlitze 25, 26, 27, 28, 29, 30 zugeordnet, durch die am Zähler angeordnete Kontaktfahnen ins Innere des Zählertraggehäuses 10 eingeführt und mit den zugehörigen Kontaktstücken in Verbindung gebracht werden.

Der zugangsseitige Neutralleiter 17d und der abgangsseitige Neutralleiter 19d sind im Inneren des Zählertraggehäuses elektrisch verbunden, so dass insgesamt ein Neutralleiter durch das Zählertraggehäuse 10 hindurchgeschleift ist.

Wie aus der Fig. 1 ersichtlich ist, sind die Schlitze 25, 26,27,28, 29 und 30 - natürlich ebenso wie die zugehörigen und darunter liegenden Kontaktstücke - gegeneinander versetzt, wie dies auch in der oben erwähnten DE 10 2004 022 785 der Fall ist.

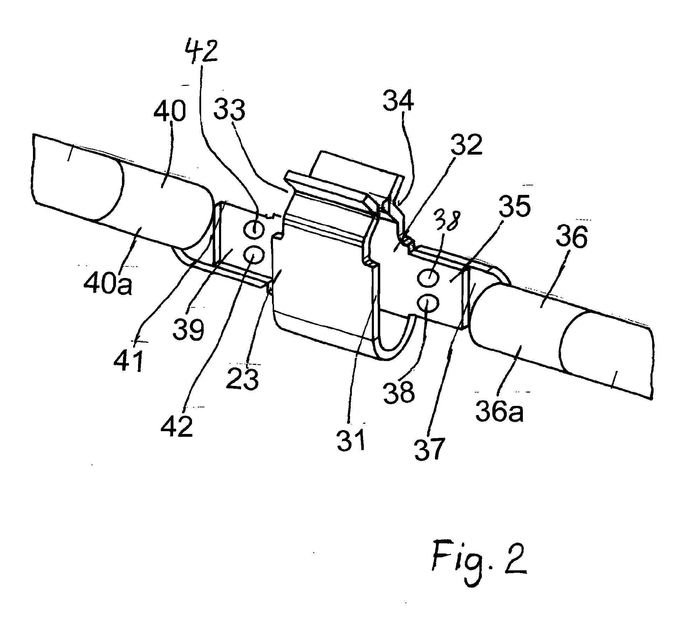

In der Fig. 2 ist ein Kontaktstück dargestellt, an dem jeweils ein Teilstück eines zugangsseitigen und eines abgangsseitigen Neutralleiters 17d, 19d, befestigt sind. Das Kontaktstück trägt die Bezugsziffer 23.

Das Kontaktstück 23 ist als U-förmiges Kontaktstück ausgebildet und besitzt zwei Schenkel 31 und 32, an deren freien Enden eine Einkerbung 33, 34 vorgesehen ist, wodurch sich der Abstand der beiden Schenkel in diesem Endbereich zwischen den Einkerbungen 33, 34 verkleinert; eine Kontaktfahne am Zähler greift zwischen die Schenkel und kontaktiert mit den Innenflächen der Einkerbungen 33, 34; diese Innenflächen der Einkerbungen 33, 34 bilden Kontaktflächen.

An dem Schenkel 32 ist eine erste, zugangsseitige Anschlussfahne 35 angeformt. Das Ende des zugangsseitigen Neutralleiter-Teilstücks 17d ist abisoliert und mit einem Kabelschuh 36 verbunden, der eine zusammendrückbare, zylindrische Aufnahme 36a für das abisolierte Ende des Neutralleiter-Teilstücks 17d und eine Kontaktfahne 37 aufweist, die an der Anschlussfahne 35 mit Schweißpunkten 38 befestigt ist.

Weiter ist an dem Schenkel 32 gegenüber der zugangsseitigen Anschlussfahne 35 eine zweite, abgangsseitige Anschlussfahne 39 angeformt. Das Ende des abgangsseitigen Neutralleiters 19d ist ebenfalls abisoliert und mit einem Kabelschuh 40 verbunden, der eine zusammendrückbare, zylindrische Aufnahme 40a für das abisolierte Ende des Leiters 19d und eine Kontaktfahne 41 aufweist, die an der Anschlussfahne 39 mit Schweißpunkten 42 befestigt ist.

Somit bewirkt das Kontaktstück 23 einerseits die elektrische und mechanische Verbindung zwischen den beiden Neutralleiter-Teilstücken 17d, 19d, so dass von außen der Effekt eines einzigen, durch das Innere des Zählertraggehäuses durchgeschleiften Neutralleiters bewirkt wird. Andererseits ermöglicht das Kontaktstück 23 den elektrischen Kontakt des Neutralleiters zu dem Zähler.

Bei einer weiteren Ausführung, die allerdings nicht durch eine Figur dargestellt ist, schließen an dem Schenkel des Kontaktstückes beidseitig je eine zugangsseitige und eine abgangsseitige Anschlussfahne an, die an ihrem freien Ende eine Abwinklung tragen, die senkrecht zu der jeweils zugangsseitigen und abgangsseitigen Anschlussfahne verläuft und hin zum Schenkel weist. An der Abwinklung sind Crimpelemente vorgesehen, zwischen die jeweils das abisolierte Ende des Neutralleiters eingeführt wird; danach werden die Crimpelemente durch Verformen in an sich bekannter Weise mit dem jeweiligen Neutralleiter verquetscht.

In einer weiteren, ebenfalls nicht durch eine Figur dargestellten Ausführungsform ist an einem Schenkel des Kontaktstücks beidseitig je eine zugangsseitige und eine abgangsseitige Anschlussfahne angeformt, auf deren dem Schenkel zugewandten Fläche Crimpelemente angeformt sind zwischen die jeweils die Neutralleiter mit ihren abisolierten Enden gesteckt werden; danach werden die Crimpelemente mit den Neutralleitern verquetscht. Der Unterschied zwischen dieser Ausführung und der davor beschriebenen besteht darin, dass die Anschlussfahne in letzterer eine Abwinklung trägt, an deren Außenfläche die Crimpelemente angeformt sind, wogegen die Anschlussfahnen in ersterer ohne Abwinklung ausgebildet sind.

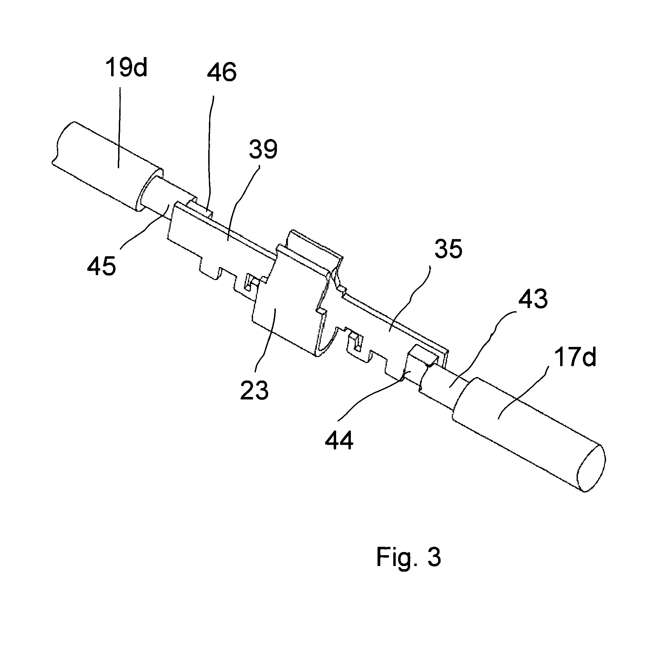

Die Figur 3 zeigt eine Ausführungsform, bei der das freie Ende 43 des zugangsseitigen Neutralleiter-Teilstücks 17d an einem Schweißpunkt 44 direkt auf der Anschlussfahne 35 angeschweißt ist. Ebenso ist das freie Ende 45 des abgangsseitigen Neutralleiter-Teilstücks 19d an einem Schweißpunkt 46 direkt auf der Anschlussfahne 39 angeschweißt. Anstatt zu schweißen könnte an der Anschlussfahne 35 und der Anschlussfahne 39 auch eine Lötverbindung direkt zwischen den freien Enden 43 bzw. 45 des zugangs- bzw. abgangsseitigen Neutralleiters 17d, 19d bestehen. Mit dem direkten Anschweißen bzw. Anlöten gemäß der Ausführungsform nach Fig. 3 ist ein Minimum an Aufwand erforderlich, um eine schraubenlose Verbindung zwischen den freien Enden des zugangsseitigen und des abgangsseitigen Neutralleiters und den Anschlussfahnen zu bewirken.

Die vorliegende Erfindung umfasst neben den beschriebenen Ausführungsbeispielen auch beliebige Kombinationen bevorzugter Ausführungsformen sowie einzelner Ausgestaltungsmerkmale oder Weiterbildungen, sofern diese sich nicht gegenseitig ausschließen.

### Bezugszeichenliste

- 10: Zählertraggehäuse
- 11: Gehäuseunterteil
- 12: Gehäuseoberteil
- 13: Rastarm
- 14: Schmalseitenwand
- 15: Schmalseitenwand
- 16: Zugangsöffnung
- 17a: Phasenleiter
- 17b: Phasenleiter
- 17c: Phasenleiter
- 17d: Neutralleiter-Teilstück
- 19a: Phasenleiter
- 19b: Phasenleiter
- 19c: Phasenleiter
- 19d: Neutralleiter-Teilstück
- 20: Gehäuseabschnitt
- 21: Gehäuseabschnitt
- 23: Kontaktstück
- 25: Schlitz
- 26: Schlitz
- 27: Schlitz
- 28: Schlitz
- 29: Schlitz
- 30: Schlitz
- 31: Schenkel
- 32: Schenkel
- 33: Einkerbung
- 34: Einkerbung
- 35: zugangsseitige Anschlusssfahne
- 36: Kabelschuh
- 36a: zylindrische Aufnahme
- 37: Kontaktfahne
- 38: Schweißpunkt
- 39: abgangsseitige Anschlussfahne
- 40: Kabelschuh
- 40a: zylindrische Aufnahme
- 41: Kontaktfahne
- 42: Schweißpunkt
- 43: freies Ende des Neutralleiters
- 44: Schweißpunkt
- 45: freies Ende des Neutralleiters
- 46: Schweißpunkt

## Patentansprüche

1. Zählertraggehäuse (10) für einen Zählerschrank zur Montage eines Zählers,
- mit wenigstens einer ersten zugangsseitigen Einführöffnung (16) für die Aufnahme wenigstens eines zugangsseitigen Phasenleiters (17a, 17b, 17c),
- mit einer zweiten zugangsseitigen Einführöffnung für die Aufnahme eines zugangsseitigen Neutralleiters (17d), und
- mit wenigstens einer ersten ausgangsseitigen Abgangsöffnung für die Aufnahme wenigstens eines abgangsseitigen Phasenleiters (19a, 19b, 19c), wobei der zugangsseitig eingeführte Neutralleiter (17d) im Inneren des Zählertraggehäuses (10) von der ersten zugangsseitigen Einführöffnung aus elektrisch zu einer zweiten ausgangsseitigen Abgangsöffnung durchschleifbar ist,
- mit wenigstens einem U-förmigen Kontaktstück (23), mit dem eine am Stromzähler befindliche Kontaktfahne bei der Montage des Stromzählers in Eingriff bringbar ist, wobei die Kontaktfahne durch einen Schlitz (29, 30) hindurch ins Innere des Zählertraggehäuses (10) einführbar ist,
**dadurch gekennzeichnet, dass** an dem U-förmigen Kontaktstück (23) eine zugangsseitige Anschlussfahne (35) und eine abgangsseitige Anschlussfahne (39) angeformt sind, und dass an der zugangsseitigen Anschlussfahne (38) ein zugangsseitig eingeführtes Neutralleiter-Teilstück (17d) und an der abgangsseitigen Anschlussfahne (39) ein in der zweiten ausgangsseitigen Abgangsöffnung eingeführtes abgangsseitiges Neutralleiter-Teilstück (19d) anschließbar sind.

2. Zählertraggehäuse (10) nach Anspruch 1, **dadurch gekennzeichnet, dass** das zugangsseitige und das abgangsseitige Neutralleiter-Teilstück (17d, 19d) an der zugangsseitigen bzw. der abgangsseitigen Anschlussfahne (35, 39) schraubenlos anformbar sind.

3. Zählertraggehäuse (10) nach Anspruch 2, **dadurch gekennzeichnet, dass** das zugangsseitige und das abgangsseitige Neutralleiter-Teilstück (17d, 19d) an der zugangsseitigen bzw. der abgangsseitigen Anschlussfahne (35, 39) anschweißbar sind.

4. Zählertraggehäuse (10) nach Anspruch 2, **dadurch gekennzeichnet, dass** an dem in das Zählertraggehäuse (10) einführbaren Ende des zugangsseitigen und des abgangsseitigen Neutralleiter-Teilstücks (17d, 19d) jeweils ein Kabelschuh (36, 40) mit einer zylindrischen Aufnahme (36a, 40a) befestigbar ist, wobei die zylindrischen Aufnahmen (36a, 40a) mit der zugangsseitigen bzw. der abgangsseitigen Anschlussfahne (35, 39) schraubenlos verbindbar sind.

5. Zählertraggehäuse (10) nach Anspruch 4, **dadurch gekennzeichnet, dass** die zylindrischen Aufnahmen (36a, 40a) an der zugangsseitigen bzw. der abgangsseitigen Anschlussfahne (35, 39) anschweißbar sind.

6. Zählertraggehäuse (10) nach Anspruch 4, **dadurch gekennzeichnet, dass** die zylindrischen Aufnahmen (36a, 40a) mit der zugangsseitigen bzw. der abgangsseitigen Anschlussfahne (35, 39) verlötbar sind.

7. Zählertraggehäuse (10) nach Anspruch 2, **dadurch gekennzeichnet, dass** an der zugangsseitigen bzw. der abgangsseitigen Anschlussfahne (35, 39) ein Crimpelement angeformt ist, mit dem der zugangsseitige und der abgangsseitige Neutralleiter (17d, 19d) mit der zugangsseitigen bzw. der abgangsseitigen Anschlussfahne (35, 39) vercrimpbar ist.

8. Zählertraggehäuse (10) nach einem der Ansprüche 1 bis 7, **dadurch gekennzeichnet, dass** die zugangsseitige und die abgangsseitige Anschlussfahne (35, 39) an demselben Schenkel (32) des U-förmigen Kontaktstücks (23) anformbar sind.

9. Zählerschrank mit einem Zählertraggehäuse (10) nach einem der vorigen Ansprüche.
